# EUROPÄISCHE PATENTSCHRIFT

(11) **EP 0 942 300 B1**
(45) Veröffentlichungstag und Bekanntmachung des Hinweises auf die Patenterteilung: **28.07.2004**
(21) Anmeldenummer: 99102483.7
(22) Anmeldetag: 10.02.1999
(51) Int. Cl.: G02F 1/01

(54) **Doppelbrechende Plattenanordnung mit Spannungsdoppelbrechung**
Birefringent plate with stress-induced birefringence
Plaque biréfringente avec biréfringence par compression

(30) Priorität: 10.03.1998 DE 19810089
(43) Veröffentlichungstag der Anmeldung: 15.09.1999
(73) Patentinhaber: Carl Zeiss SMT AG, 73447 Oberkochen (DE)
(72) Erfinder: Becker, Jochen, 73447 Oberkochen (DE)
(74) Vertreter: Schultz, Jörg Martin, Dipl.-Phys.

(56) Entgegenhaltungen:
- DE-A- 3 002 955
- FR-A- 1 174 134
- GB-A- 1 098 897
- US-A- 3 867 014
- PATENT ABSTRACTS OF JAPAN vol. 014, no. 264 (P-1057), 7. Juni 1990 (1990-06-07) & JP 02 073215 A (HITACHI LTD), 13. März 1990 (1990-03-13)
- PATENT ABSTRACTS OF JAPAN vol. 1995, no. 01, 28. Februar 1995 (1995-02-28) & JP 06 296051 A (SADAO NAKAI;OTHERS: 02), 21. Oktober 1994 (1994-10-21)
- DELPLANCKE F ET AL: "SIMPLE PROCESS FOR BUILDING LARGE HOMOGENEOUS ADAPTABLE RETARDERS MADE FROM POLYMERIC MATERIALS" APPLIED OPTICS,US,OPTICAL SOCIETY OF AMERICA,WASHINGTON, Bd. 34, Nr. 16, Seite 2921-2926 XP000506373 ISSN: 0003-6935

## Beschreibung

Die Erfindung betrifft eine doppelbrechende Plattenanordnung mit Spannungsdoppelbrechung gemäß dem Oberbegriff des Anspruches 1. Solche sind aus GB 1 098 897 A1, JP 02-073215 A und US 3,867,014 A bekannt.

Es ist bekannt, daß durch Drücken oder Dehnen eines zunächst isotropen Materials Spannungsdoppelbrechung erzeugt werden kann.

Festkörperlaser werden polarisiert durch seitliches Drücken des Laserkristalls. Hierbei wird jedoch kein quantitativ sauberer Doppelbrechungseffekt erzielt, es genügt eine Verstimmung des Resonators.

In der nicht vorveröffentlichten DE 196 37 563.0 (entspricht US Serial No. 08/929,913) ist eine gattungsgemäße Anordnung mit Zugspannung beschrieben. Die Anwendung von Druck wird aus konstruktiven Gründen abgelehnt und allenfalls als Zusatz orthogonal zum Zug vorgesehen. Der Inhalt dieser Anmeldung wird jedoch hier zitiert, da insbesondere das technische Umfeld und die Bedeutung dieser Erfindung daraus sehr gut hervorgeht.

Aufgabe der Erfindung ist es, eine doppelbrechende Plattenanordnung mit Spannungsdoppelbrechung anzugeben, welche sehr homogene Spannungsdoppelbrechung in einem möglichst großen Querschnittsanteil einer dünnen Platte bei geringster Deformation aufweist und kompakt, stabil und betriebssicher aufgebaut werden kann.

Dies gelingt mit einer Plattenanordnung nach Anspruch 1. Dabei ist es besonders bedeutend, daß die Abmessungen der Anordnung durch gestufte Querschnittsform der Platte nach Anspruch 3 günstig an runde Fassungen runder optischer Elemente in der Umgebung der Platte angepaßt werden können.
Überraschend wurde festgestellt, daß die noch in DE 196 37 563 gesehene Schwierigkeit des Durchbiegens unter Druck gut beherrschbar ist bei sorgfältiger Ausführung der Ankopplung der Glasplatte an die Druckelemente.

. Die Druck- und Schubspannungen sind dabei einfacher in die geeigneten Glaswerkstoffe der spannungsdoppelbrechenden Platte einzubringen, da Kraftschluß auf Druck ohne besondere Formgebung des Glaswerkstoffes möglich wird.

Vorteilhafte Weiterbildungen sind Gegenstand der Unteransprüche.

Auch sind die Vorteile der Hydraulik gemäß den Ansprüchen 4, 5, 8 und 9 beträchtlich für die sehr gleichmäßige Spannungseintragung.

Dabei können als Hydraulik-Medien grundsätzlich alle Fluide, neben Flüssigkeiten auch Gase, eingesetzt werden. Elastische Hüllen für das Hydraulikmedium, insbesondere Schläuche und Membranen gemäß Anspruch 9 ergeben eine einfache dauerhaft leckfreie Konstruktion.

Näher erläutert wird die Erfindung anhand der Zeichnung.
- Figur 1: zeigt ein Ausführungsbeispiel mit abgestufter spannungsdoppelbrechender Platte und hydraulischer Druckeinleitung;
- Figur 2: zeigt schematisch einen Ausschnitt aus Figur 1 und schematisch die Hydraulik;
- Figur 3: zeigt eine Prinzipdarstellung einer Anordnung mit Schubspannung; und
- Figur 4: zeigt ein Beispiel einer gestuften doppelbrechenden Platte für die Einleitung von Schubspannungen.

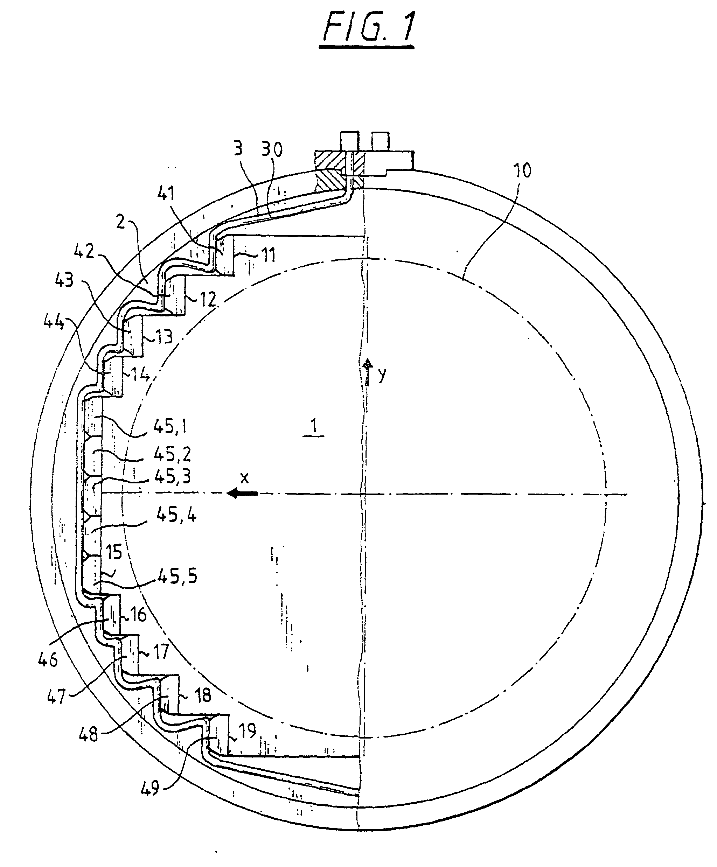

Figur 1 zeigt eine mit Druck funktionierende spannungsdoppelbrechende Planplatte, die als Lambdaviertel-Platte im tiefen Ultraviolett-Bereich, z.B. bei der Excimer-Laser-Linie 193 nm brauchbar ist.

Ein freier Durchmesser für ein Lichtbündel 10 von 240 mm wird bei einem Außendurchmesser der Konstruktion von 330 mm realisiert. Die Planplatte besteht aus Quarzglas in für die Mikrolithographie im DUV üblicherweise spezifizierter Güte und hat eine Dicke von nur 6 mm. Die Dicke der Fassung kann dabei auf ca. 12 mm begrenzt werden.

Die Form der Quarzplatte 1 ist als den Kreis des Lichtbündels 10 einhüllende Rechteckstufenform ausgebildet, wobei jede Stufe 11-19 gleiche Breite aufweist, Symmetrie zur x-Achse gegeben ist und mittig mehrere (hier 5) Stufen gleichen Abstands zur y-Achse zusammengefaßt sind.

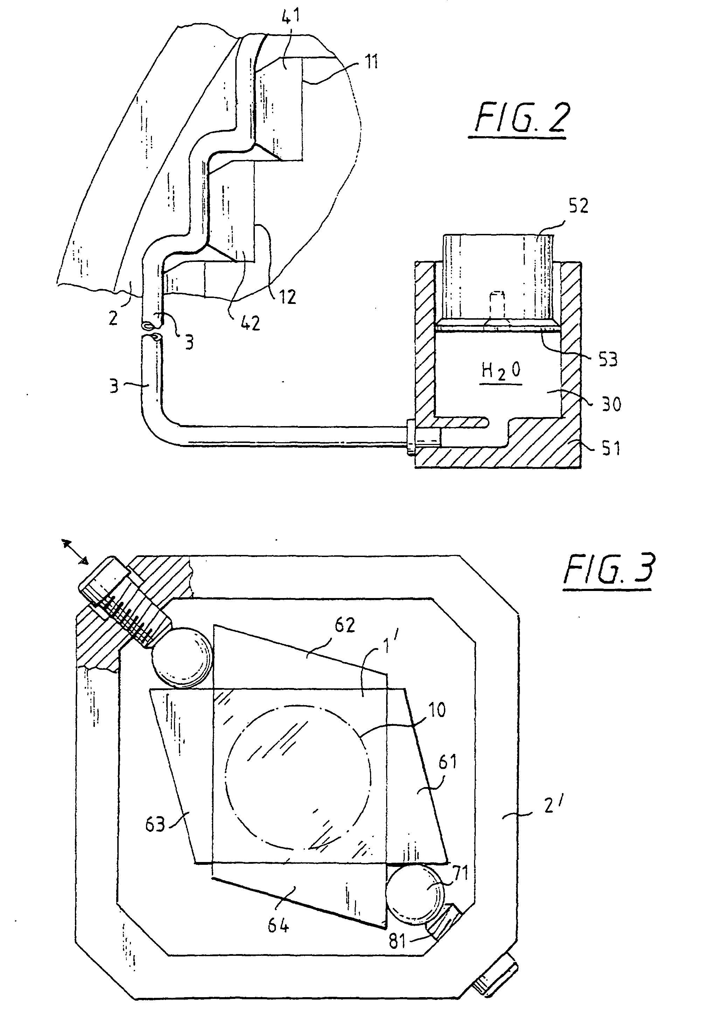

Die ganze Anordnung ist zur y-Achse spiegelsymmetrisch (wie auch zur x-Achse). Figur 2 zeigt dazu zunächst ausschnittsweise eine Detailansicht. Alle zur y-Achse parallelen Stufenflächen 11-19 sind hochgenau eben und parallel. Daran angelegt sind Druckschuhe 41-49. Alle sind gleich und weisen exakt parallele Deckflächen auf. Die an die Stufen 11-19 angelegten Deckflächen weisen exakt deren Abmessungen auf, um keine Lücken in der Druckeintragung in die Quarzglasplatte 1 entstehen zu lassen.

Es ist vorgesehen, die Stufen 11-19 und die Anlageflächen der Druckschuhe 41-49 fein zu ätzen, da mit solcher Mikrorauhigkeit die gleichmäßige Druckübertragung optimiert wird.

Es ist möglich, die elastische Verformung der Druckschuhe 41-49 unter Last vorzuhalten, also gekrümmt zu fertigen, so daß unter Last die Flächen eben werden.

Die zweite Deckfläche der Druckschuhe 41-49 liegt an einem durchgehenden elastischen Hydraulikschlauch 3 an, der mit Hydraulikfluid 30, vorzugsweise destilliertem Wasser, gefüllt isc und sich gegen Anlageflächen des Fassungsrings 2 abstützt. Alle zweiten Deckflächen der Druckschuhe 41-49 sind ebenfalls gleich groß und vollständig vom Hydraulikschlauch 3 bedeckt. Die Fläche ist etwas kleiner als und mittenzentriert gegenüber den parallelen Deckflächen an den Stufen 11-19 der Glasplatte 1.

Das Hydraulikfluid 30 wird mit vorbestimmtem Druck beaufschlagt, vorzugsweise wie in Figur 2 schematisch dargestellt, über einen Zylinder 51 mit Kolben 52, dessen Gewichtskraft den Druck bestimmt. Eine Dichtung 53 vermeidet Flüssigkeitsverlust.

Allein die Präzision der Planplatte 1 mit den Stufen 11-19 und der Druckschuhe 41-49 bestimmt damit die Homogenität der Druckbelastung der Planplatte 1. Die Größe des Drucks ist, soweit nicht Schwingungs- oder Stoßeffekte auftreten - was in der Umgebung einer Mikrolithographie-Anlage gut vermieden werden kann - allein durch das Gewicht des Kolbens 52 und festgelegte Geometrieparameter bestimmt.

Insbesondere können unterschiedliche Wärmeausdehnungen der Teile - Glasplatte 1, Metallfassung 2, Hydraulikfluid 30 usw. nicht zu Druckänderungen führen.

Eine Quarzglasplatte 1 von 6,00 mm Dicke erreicht eine Doppelbrechung, die eine Phasenverschiebung von Lambda/4 bei 193 nm ergibt, unter einem Druck in der Plattenebene von 1,618 N/mm².

Dies wird bei der in Figur 1 gezeigten Konstruktion bei einem Druck des Hydraulikfluids 30 von etwa 20 bar erreicht.

Diese Drücke sind also einfach handhabbar, als elastischer Hydraulikschlauch 3 kann ein handelsüblicher Schlauch von z.B. 6,5 mm Durchmesser mit 0,3 mm Wandstärke aus Butylkautschuk Verwendung finden. Mit Wasser als Hydraulikflüssigkeit 30 bestehen keine nennenswerten Gefahrenpotentiale.

Die Durchbiegung der Quarzglasplatte 1 bei horizontalem Einbau unter ihrem Eigengewicht beträgt mittig ca. 5 µm.

Bei einwandfreier Fertigung der Gesamtkonstruktion gelingt es, die Druchbiegung unter Betriebsdruck auf einzelne Mikrometer zu beschränken. Das früher vorausgesetzte Risiko einer unzulässigen Verbiegung unter Druck konnte also ausgeschaltet werden.

Die Homogenität der Doppelbrechung im Quarzglas 1 kann im Querschnitt 10 auf unter 5 % Betrags- und unter 5° Winkelabweichung sichergestellt werden.

Alternativ können Platten auch durch Konstruktionen ähnlich den in DE 196 37 563 beschriebenen homogen mit Druck beaufschlagt werden. Bei der Konstruktion ist dabei vor allem auf die Vermeidung einer Belastung der Glasplatte mit Momenten zu achten. Durch geeignete Materialkombinationen kann auch hier eine thermosymmetrische Ausbildung erreicht werden.

Neben den oben beschriebenen Ausführungen einer spannungsdoppelbrechenden Platte unter Druckspannung und den in DE 196 37 563 beschriebenen mit Zugspannung haben auch Ausführungen mit Schubspannung ihre Bedeutung dadurch, daß die gleiche doppelbrechende Wirkung mit halb so großen Kräften erreicht wird, die allerdings in zwei zueinander orthogonalen Richtungen aufzubringen sind. Die Durchbiegung unter Last wird dadurch prinzipiell bis zum Faktor ½ verringert.

Figur 3 zeigt dazu einen Aufbau, bei dem an eine quadratische Quarzglasplatte 1' mit dem optisch genutzten Querschnitt 10 an den vier Seiten starre Balken 61-64 gleichmäßig kraftschlüssig angebracht sind.

Diese Baugruppe ist über Druckkugeln 71, 72 und Druckstücke 81, 82 in einen Rahmen 2' eingespannt. Wichtig ist, daß die Balken 61-64 wesentlich steifer als die Quarzplatte 1' sind, deshalb sind sie vorzugsweise aus Hartmetall gefertigt. Der Kraftschluß wird durch Stoffschluß, insbesondere durch Löten oder Kleben erreicht. Letzteres ist bei weniger kritischer UV-Strahlungsbelascung geeignet.

Die Druckstücke 81, 82 können als einstellbare Spannmittel bekannter Bauarten ausgebildet werden und können auch durch geeignete Dimensionierung und Materialwahl zur thermosymmetrischen Auslegung herangezogen werden.

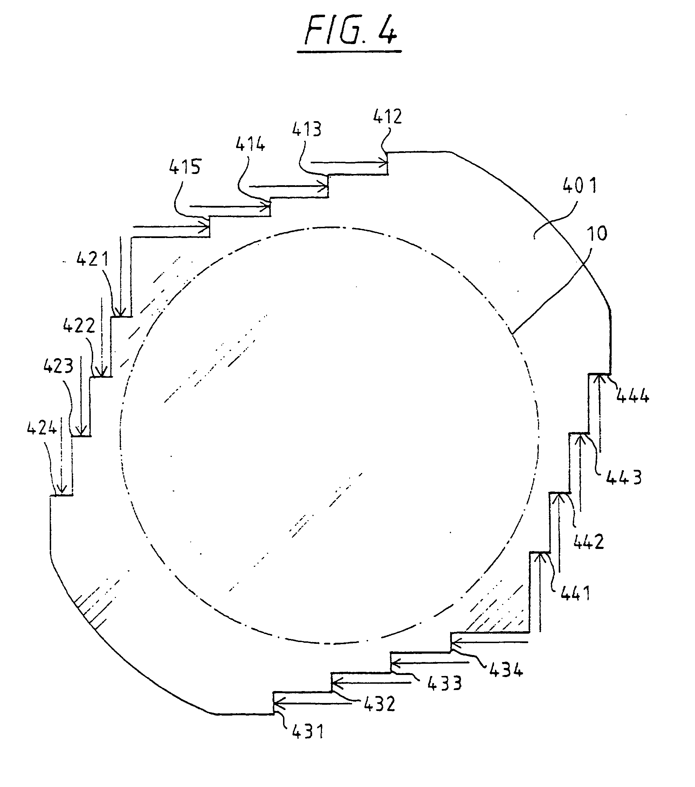

Ein weiteres Ausführungsbeispiel zeigt Figur 4. Hier ist zur Krafteinleitung in die (Quarzglas) Platte 401 keine stoffschlüssige Verbindung erforderlich und die Außenabmessung des Aufbaus ist näher an den Nutzdurchmesser des Querschnitts 10 angepaßt.

Die Platte 1 weist dazu Stufen 411-414, 421-424, 431-434 und 441-444 auf, auf die jeweils in der aus Figur 1 und 2 bekannten Art Druck gleichmäßig aufgebracht wird. Durch Anzahl und Breite der Stufen 411-444 läßt sich so in erforderlicher Güte eine Näherung an die Einbringung der Schubkräfte entsprechend Figur 3 erreichen. Alle Vorteile der Konstruktion nach Figur 1 und 2 lassen sich so mit den Eigenschaften der Schubspannung verbinden.

Vorzugsweise werden die erfindungsgemäßen spannungsdoppelbrechenden Platten als planparallele Platten ausgeführt. Zum Vorhalt einer Durchbiegung (unter Gewicht und Spannung) können Radien vorgehalten werden. Jedoch ist die Anwendung auch bei anderen Plattenformen einschließlich Prismen und Linsen möglich.

Die Anwendung im DUV-Bereich, besonders bei Mikrolithographie-Optiken und bei Meßinstrumenten ist besonders wichtig, da dort die üblichen preiswerten doppelbrechenden Elemente und Schichten photochemisch nicht tauglich sind.

## Patentansprüche

1. Doppelbrechende Plattenanordnung mit Spannungsdoppelbrechung, wobei an den Seiten der Platte (1) Druck- oder Schubvorrichtungen (41-49) angreifen und die Platte (1) einen optischen Querschnitt (10) aufweist, der zur Transmission von Licht geeignet ist, **dadurch gekennzeichnet, daß** die Form der Platte (1) mittels Rechteckstufen (11-19) dem optischen Querschnitt (10) angenähert ist.

2. Doppelbrechende Plattenanordnung nach Anspruch 1, **dadurch gekennzeichnet, daß** die Platte (1) eine Planplatte ist.

3. Doppelbrechende Plattenanordnung nach Anspruch 1, **dadurch gekennzeichnet, daß** die Zahl der Rechteckstufen (11-19) 4 bis 25 beträgt.

4. Doppelbrechende Plattenanordnung nach mindestens einem der Ansprüche 1-3, **dadurch gekennzeichnet, daß** eine hydraulische Druckübertragung (3, 51-53) vorgesehen ist.

5. Doppelbrechende Plattenanordnung nach Anspruch 1 und Anspruch 4, **dadurch gekennzeichnet, daß** an jeder Rechteckstufe (11-19) auf beiden Seiten der Plattenanordnung je mindestens ein Übertragungsschuh (41-49) angeordnet ist, der von der hydraulischen Druckübertragung (3) beaufschlagt ist.

6. Doppelbrechende Plattenanordnung nach mindestens einem der Ansprüche 1-5, **gekennzeichnet durch** thermosymmetrische Konstruktion.

7. Doppelbrechende Plattenanordnung nach mindestens einem der Ansprüche 1-6, **dadurch gekennzeichnet, daß** Schubspannungen in die Platte (1) eingebracht werden.

8. Doppelbrechende Plattenanordnung nach mindestens einem der Ansprüche 4-7, **dadurch gekennzeichnet, daß** der Druck in der hydraulischen Druckübertragung durch ein Gewicht (52) erzeugt wird.

9. Doppelbrechende Plattenanordnung nach mindestens einem der Ansprüche 4-8, **dadurch gekennzeichnet, daß** elastische Hüllen, insbesondere Schläuche oder Membranen, (3) für das Hydraulik-Medium (30) vorgesehen sind.

## Claims

1. Birefringent plate arrangement with stress-induced birefringence, pressing or thrusting devices (41-49) acting on the sides of the plate (1), and the plate (1) having an optical cross section (10) which is suitable for the transmission of light, **characterized in that** the shape of the plate (1) is approximated to the optical cross section (10) by means of rectangular steps (11-19).

2. Birefringent plate arrangement according to Claim 1, **characterized in that** the plate (1) is a plane plate.

3. Birefringent plate arrangement according to Claim 1, **characterized in that** the number of the rectangular steps (11-19) is 4 to 25.

4. Birefringent plate arrangement according to at least one of Claims 1-3, **characterized in that** a hydraulic pressure transmission (3, 51-53) is provided.

5. Birefringent plate arrangement according to Claim 1 and Claim 4, **characterized in that** arranged at each rectangular step (11-19) on both sides of the plate arrangement is in each case at least one transmission shoe (41-49) to which the hydraulic pressure transmission (3) is applied.

6. Birefringent plate arrangement according to at least one of Claims 1 to 5, **characterized by** a thermally symmetric design.

7. Birefringent plate arrangement according to at least one of Claims 1-6, **characterized in that** shear stresses are introduced into the plate (1).

8. Birefringent plate arrangement according to at least one of Claims 4-7, **characterized in that** the pressure in the hydraulic pressure transmission is produced by a weight (52).

9. Birefringent plate arrangement according to at least one of Claims 4-8, **characterized in that** elastic sheaths, in particular tubes or diaphragms (3), are provided for the hydraulic medium (30).

## Revendications

1. Plaque biréfringente avec biréfringence par compression, des dispositifs de compression ou de poussée (41-49) étant en prise sur les côtés de la plaque (1) et la plaque (1) présentant une section transversale optique (10) qui convient pour la transmission de la lumière, **caractérisée en ce que** la forme de la plaque (1) est rapprochée de la section transversale optique (10) au moyen d'étages rectangulaires (11-19).

2. Plaque biréfringente selon la revendication 1, **caractérisée en ce que** la plaque (1) est une plaque plane.

3. Plaque biréfringente selon la revendication 1, **caractérisée en ce que** le nombre d'étages rectangulaires (11-19) est compris entre 4 et 25.

4. Plaque biréfringente selon au moins l'une des revendications 1 à 3, **caractérisée en ce qu'**il est prévu une transmission hydraulique de la pression (3, 51-53).

5. Plaque biréfringente selon la revendication 1 et la revendication 4, **caractérisée en ce qu'**au moins un sabot de transmission (41-49) qui est soumis à la transmission hydraulique de la pression (3) est à chaque fois monté sur chaque étage rectangulaire (11-19) des deux côtés de la plaque.

6. Plaque biréfringente selon au moins l'une des revendications 1 à 5, **caractérisée par** une construction thermosymétrique.

7. Plaque biréfringente selon au moins l'une des revendications 1 à 6, **caractérisée en ce que** des contraintes de poussée sont appliquées dans la plaque (1).

8. Plaque biréfringente selon au moins l'une des revendications 4 à 7, **caractérisée en ce que** la pression dans la transmission hydraulique de la pression est générée par un poids (52).

9. Plaque biréfringente selon au moins l'une des revendications 4 à 8, **caractérisée en ce que** des gaines élastiques, notamment des tuyaux ou des membranes, (3) sont prévues pour le fluide hydraulique (30).
